# EUROPEAN PATENT APPLICATION

(11) **EP 1 693 936 A2**
(43) Date of publication of application: **23.08.2006**
(21) Application number: 06250163.0
(22) Date of filing: 13.01.2006
(51) Int. Cl.: H01S 5/187, H01S 5/026, H01S 5/06, H01S 5/183, H01S 5/04

(54) **Modulator integrated semiconductor laser device**

(30) Priority: 16.02.2005 KR 2005012920
(71) Applicant: Samsung Electronics Co., Ltd., Suwon-si Gyeonggi-do (KR)
(72) Inventor: Kim, Taek, Seongnam-si, Gyeonggi-do (KR)
(74) Representative: Greene, Simon Kenneth

(57) **Abstract**

A modulator integrated semiconductor laser device is provided. In the modulator integrated semiconductor laser device, a lower DBR (distributed Bragg reflector) layer (61) is formed on the substrate (60), an active layer (62) is formed on the lower DBR layer and includes a plurality of barrier layers alternating with a plurality of quantum well layers, and an external mirror (71) is spaced apart from a top of the active layer to output a portion of light emitted from the active layer by transmission and to reflect the remainder to the active layer. Two of the plurality of barrier layers (65a,65b) that contact both sides of at least one (65c) of the plurality of quantum well layers are doped with different types.

## Description

The present invention relates to a modulator integrated semiconductor laser device, and more particularly, to a modulator integrated semiconductor laser device in which at least one quantum well layer is shared with a modulator by doping portions of barrier layers.

Lasers are widely used as light emitting devices for various applications such as printers, scanners, medical equipment, optical communication equipment, and laser TVs. Lasers produce digital signals by periodically varying their output power. This operation is called modulation, and high frequency modulation is used particularly in optical communications.

There are methods of modulating the optical output power of a laser into a high frequency. In direct modulation, a current applied to a laser device is varied for the high frequency modulation. In another method, the laser device is oscillated continuously and a separate modulator is used to modulate the laser light.

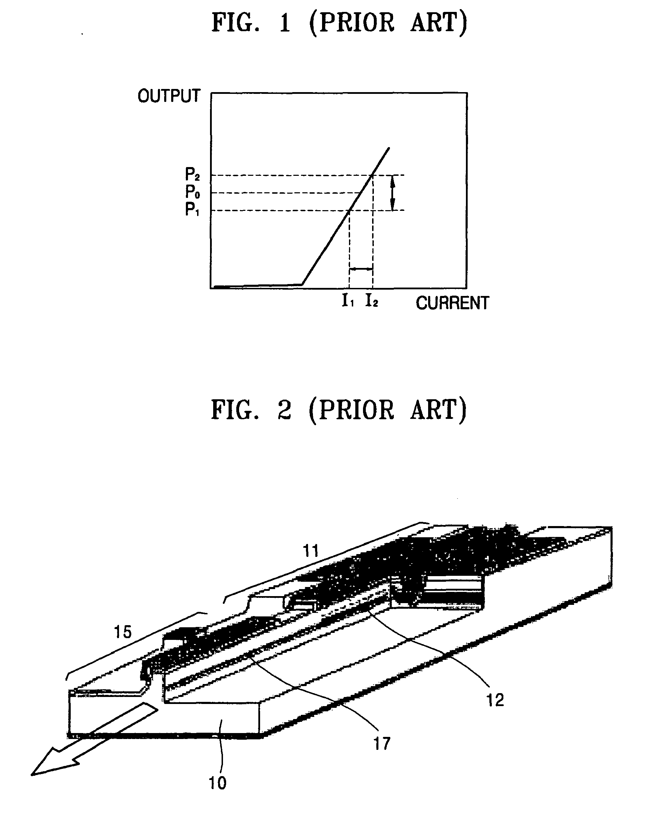

FIG. 1 is a graph showing the principle of direct modulation. Referring to FIG. 1, in direct modulation, a current applied to a laser is varied over a range (I₁ - I₂) to obtain a predetermined output power (P₁. P₂) from the laser. In digital optical communication, for example, if the output power of the laser is larger than a reference value P₀, the signal is "1", and if not, the signal is "0". According to such a direct modulation, if the slope of the output power is large, the current can be varied over a small range, thereby allowing high frequency modulation at ten gigahertz or more, with a relatively simple modulation circuit.

However, in application fields such as laser TVs, the grayscale is controlled by the duty cycle of the laser. This requires the current to be varied over a wide range. Therefore, direct modulation is not suitable for such applications. That is, in the laser TV, the optical output power of a laser is modulated between the lowest optical output power and the highest output power of the laser. For example, since a high power laser of a laser TV requires a high current of 10 amperes or more to generate an output power of up to several watts, the current variation range is 10 amperes or more for the direct modulation method, thereby making high speed modulation impossible. Therefore, in this case, an additional modulator is installed with the laser device for high speed modulation.

FIG. 2 is a cut-away view of a conventional edge emitting laser in which a modulator is attached to a light emitting portion. Referring to FIG. 2, a modulator 15 adjoins a light emitting portion of an edge emitting laser 11 and is formed integral with the edge emitting laser 11. The edge emitting laser 11 and the modulator 15 are formed on the same substrate 10 and commonly include layers 12 and 17 that are formed of the same material, such as InGaAsP. However, the layer 12 of the edge emitting laser 11 acts as a quantum well layer to generate light, and the layer 17 of the modulator 15 acts as a light absorbing layer.

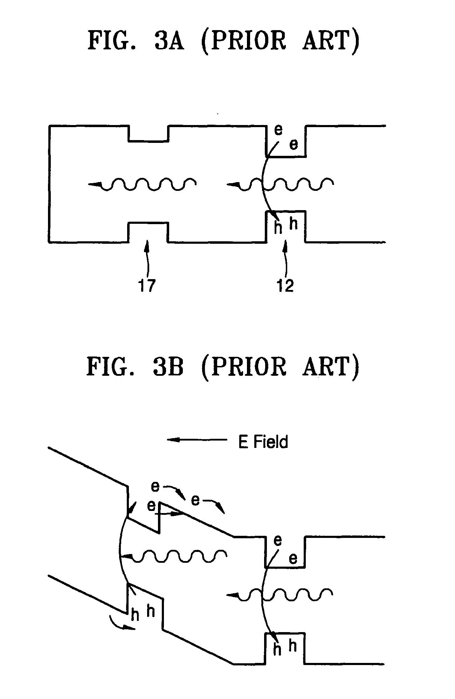

FIGS. 3A and 3B are energy band graphs showing the operational principle of the edge emitting laser depicted in FIG. 2. As shown in FIG. 2, since the modulator 15 is narrower than the edge emitting laser 11, the light absorbing layer 17 usually has a slightly wider band gap than the quantum well layer 12. In this condition, when the edge emitting laser 11 starts to oscillate, light generated by the quantum well layer 12 passes through the light absorbing layer 17; however, when a reverse bias is applied to the modulator 15 as shown in FIG. 3B, the band gap of the light absorbing layer 17 becomes narrower according to the quantum confined stark effect and thus the light is absorbed by the light absorbing layer 17. Therefore, the optical output power of the laser can be modulated at a high speed by periodically adjusting the reverse bias applied to the modulator 15. However, when a modulator is outside a laser, light output from the laser cannot be 100% absorbed by the modulator. That is, the emitted laser beam cannot be completely switched on or off.

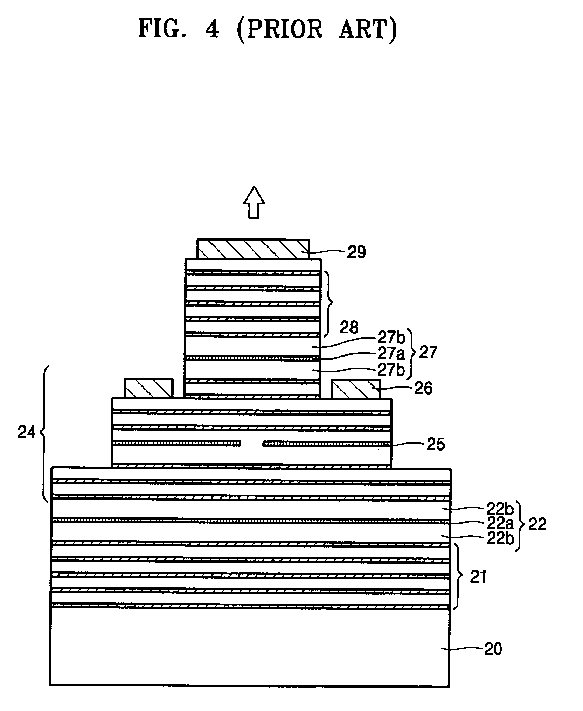

Therefore, as shown in FIG. 4, a vertical cavity surface emitting laser (VCSEL) with a built-in modulator in a cavity has been introduced (U.S. Patent No. 6,026,108). Referring to FIG. 4, an n-doped distributed Bragg reflector (n-DBR) layer 21 is formed on an n-GaAs substrate 20, and an active layer 22 with a quantum well layer 22a and barrier layers 22b is formed on the n-DBR 21. A p-DBR layer 24 is formed on the active layer 22. In the p-DBR layer 24, an oxide layer 25 is formed to restrict current injection within a predetermined region. Further, a modulation layer 27 with spacer layers 27b and a light absorbing layer 27a is formed on the p-DBR layer 24, and an n-DBR layer 28 is formed on the modulation layer 27. That is, the VCSEL disclosed in U.S. Patent No. 6,026,108 includes the modulation layer 27 in an upper mirror.

Here, a band gap of the modulation layer 27 is larger than a band gap of the quantum well layer 22a. Therefore, when a forward current is applied through a lower electrode (not shown) of the substrate 20 and a p-electrode 26 on the p-DBR layer 24, the laser oscillates normally to emit a laser beam in the direction of the arrow. When a reverse bias is applied to the modulation layer 27 through an n-electrode 29 and the p-electrode 26, the light absorbing layer 27a of the modulation layer 27 absorbs the light by the quantum confined stark effect. As a result, light emission is stopped upon the change of the oscillation condition of the laser, and complete on/off operation of the laser can be attained.

However, since VCSELs generally have low output power (a few milliwatts), they are not suitable for laser TVs, which require a laser with at least several hundred milliwatts of power, although the VCSELs are usually used in the field of optical communication. Further, the modulation layer 27 placed in the cavity of the VSCEL does not help the oscillation of the VSCEL, thereby decreasing the efficiency of the laser. Therefore, it is very difficult to construct the laser to have an efficient oscillation configuration.

According to an aspect of the present invention, there is provided a semiconductor laser device including: a substrate; a lower DBR (distributed Bragg reflector) layer formed on the substrate; an active layer formed on the lower DBR layer and including a plurality of barrier layers alternating with a plurality of quantum well layers; and an external mirror spaced apart from a top of the active layer to transmit a portion of light emitted from the active layer and to reflect the remainder to the active layer, wherein two of the plurality of barrier layers contacting both sides of at least one of the plurality of quantum well layers are doped with different types.

When a reverse bias is applied through the doped barrier layers, the at least one quantum well layer between the doped barrier layers may absorb the light to restrain oscillation of the laser device.

The present invention provides a high power laser device with an integrated modulator.

The present invention also provides a modulator integrated semiconductor laser device in which a modulation layer is designed to contribute to the oscillation of the laser device, in order to easily meeting oscillation conditions and increase the oscillation efficiency.

According to another aspect of the present invention, there is provided a semiconductor laser device including: a substrate; a lower DBR layer formed on the substrate; an active layer formed on the lower DBR layer by alternately stacking at least one barrier layer and at least one quantum well layer; a modulator including a first doped barrier layer formed on the active layer, a modulation layer formed on the first doped barrier layer, and a second doped barrier layer formed on the modulation layer and doped with a different type from the first doped barrier layer; and an external mirror spaced apart from a top of the active layer to transmit a portion of light emitted from the active layer and to reflect the remainder to the active layer.

The first and second doped barrier layers may be formed of the same material as the barrier layer of the active layer, and the modulation layer may be formed of the same material as the quantum well layer of the active layer. Thus, the modulation layer may have the same energy band gap as the quantum well layer.

When a reverse bias is applied to the modulator through the first and second doped barrier layers, the modulation layer between the first and second doped barrier layers may absorb the light to restrain oscillation of the laser device. When the reverse bias is not applied to the modulator, the modulation layer, like the quantum well layer of the active layer, may act as a gain region. For this, the distance between the modulation layer and one of the quantum well layers adjacent to the modulation layer may be equal to 1/2 of the emission wavelength.

The semiconductor laser device may further include a window layer formed on the modulator using a material having a larger energy band gap than the active layer.

Meanwhile, the modulation layer may be partially formed on the center of an upper surface of the first doped barrier layer. In this case, a first electrode may be formed along a edge of the upper surface of the first doped barrier layer to apply a voltage to the first doped barrier layer, and a second electrode may be formed along an edge of the window layer to apply a voltage to the second doped barrier layer.

Further, the window layer may be partially formed on the center of an upper surface of the second doped barrier layer. In this case, a first electrode may be formed along a edge of the upper surface of the first doped barrier layer to apply a voltage to the first doped barrier layer, and a second electrode may be formed along an edge of an the upper surface of the second doped barrier layer to apply a voltage to the second doped barrier layer.

The semiconductor laser device may further include a pump laser to supply pumping energy to the active layer.

According to another aspect of the present invention, there is provided a semiconductor laser device including: a substrate; a lower DBR layer formed on the substrate; a modulator including a first doped barrier layer formed on the lower DBR layer, a modulation layer formed on the first doped barrier layer, and a second doped barrier layer formed on the modulation layer and doped with a different type from the first doped barrier layer; an active layer formed on the modulator by alternately stacking at least one barrier layer and at least one quantum well layer; and an external mirror spaced apart from a top of the active layer to transmit a portion of light emitted from the active layer and to reflect the remainder to the active layer.

The modulation layer may be partially formed on the top center of the first doped barrier layer and the active layer may be partially formed on the top center of the second doped barrier layer.

In this case, a first electrode may be formed along a top edge of the first doped barrier layer to apply a voltage to the first doped barrier layer, and a second electrode may be formed along a top edge of the second doped barrier layer to apply a voltage to the second doped barrier layer.

The above and other features and advantages of the present invention will become more apparent by describing in detail exemplary embodiments thereof with reference to the attached drawings in which:
FIG. 1 is a graph showing the principle of direct modulation of a laser beam;
FIG. 2 is a cut-away view of a conventional edge emitting laser in which a modulator is attached to a light emitting portion; and
FIGS. 3A and 3B are energy band graphs showing the operational principle of the edge emitting laser depicted in FIG. 2;
FIG. 4 is a sectional view of a conventional surface emitting laser in which a modulator is formed in a cavity;
FIG. 5 is a sectional view of a modulator integrated semiconductor laser device utilizing a vertical external cavity surface emitting laser (VECSEL) according to an embodiment of the present invention;
FIGS. 6A and 6B are energy band graphs showing the operational principle of a laser device according to the present invention;
FIG. 7 is a sectional view of a modulator integrated semiconductor laser device according to another embodiment of the present invention; and
FIG. 8 is a sectional view of a modulator integrated semiconductor laser device according to a further another embodiment of the present invention.

The present invention will now be described more fully with reference to the accompanying drawings, in which exemplary embodiments of the invention are shown.

Since the VCSEL shown in FIG. 4 has a low output power of a few milliwatts, it is not suitable for laser TVs requiring a laser with at least several hundred milliwatts of output power. Further, the modulator in the cavity does not help the oscillation of the laser, thereby decreasing the overall efficiency of the laser.

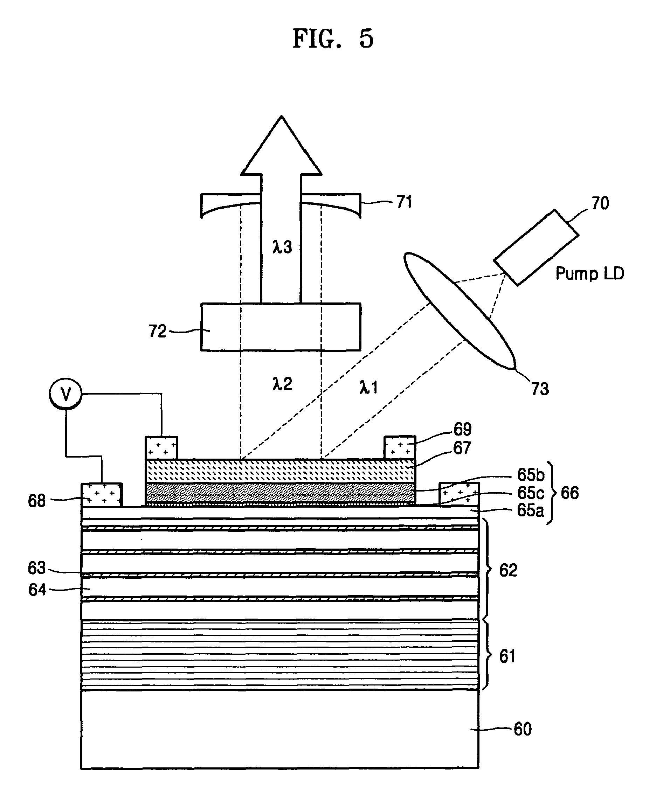

Therefore, as shown in FIG. 5, the present invention provides a modulator integrated semiconductor laser device utilizing a VECSEL having a high output power. Generally, the VECSEL can generate at least several hundred milliwatts of output power by increasing a gain region through an external mirror. According to the present invention, a modulator designed to contribute to oscillation is integrated in the high power VECSEL to obviate above-mentioned problems of the related art.

Referring to FIG. 5, a modulator integrated semiconductor laser device according to an embodiment of the present invention will now be described more specifically. The laser device includes a substrate 60, a lower DBR layer 61 formed on the substrate 60, an active layer 62 formed on the lower DBR layer 61, a modulator 66 formed on the active layer 62, and an external mirror 71. The laser device may further include a window layer 67 formed on the modulator 66 to protect the active layer 62 from the outside. The window layer 67 is formed of a material having a larger energy band gap than the active layer 62, to confine electrons and holes in the active layer 62. In addition, the laser device may further include a second harmonic generation (SHG) crystal 72 between the external mirror 71 and the window layer 67 to double the frequency of light generated by the active layer 62.

Here, the substrate 60 may be formed of material such as GaAs. The lower DBR layer 61 has a multilayer structure formed by alternating a low-refraction layer and a high-refraction layer to exhibit a high reflectance with respect to the lasing wavelength. For example, the low-refraction layer may be a GaAs layer, and the high-refraction layer may be an AlAs layer. Here, it is preferable that the distance between layers of the DBR layer 61 is equal to 1/4 of the oscillation wavelength. The active layer 62 includes at least one barrier layer 64 and at least one quantum well layer 63, alternately stacked. The quantum well layer 63 emits light at a specific wavelength by the recombination of an electron and a hole. For example, the quantum well layer 63 may be formed of InGaAs or InGaAsN, and the barrier layer 64 may be formed of undoped (AI)GaAs. Here, it is preferable that the distance between the quantum well layers 63 is equal to 1/2 of the oscillation wavelength.

Meanwhile, the modulator 66 includes a first doped barrier layer 65a formed on the active layer 62, a modulation layer 65c formed on the first doped barrier layer 65a, and a second doped barrier layer 65b formed on the modulation layer 65c and doped with a different type from the first doped barrier layer 65a. Preferably, the first and second doped barrier layers 65a and 65b are formed of the same material as the barrier layer 64 of the active layer 62, and the modulation layer 65c is formed of the same material as the quantum well layer 63 of the active layer 62. For example, the modulation layer 65c may be formed of material such as InGaAs or InGaAsN, and the first and second doped barrier layer 65a and 65b may be formed of (AI)GaAs. The modulation layer 66 is formed of a doped material, though the active layer 62 is formed of an undoped material. For example, the first doped barrier layer 65a may be formed of p-AlGaAs, and the second doped barrier layer 65b may be formed of n-AlGaAs. Therefore, the quantum well layer 63 of the active layer 62 and the modulation layer 65c of the modulator 66 have the same energy band gap.

As described above, the present invention is designed such that the modulator 66 and the active layer 62 have the same structure and are formed of the same material. Therefore, the modulator 66 can be considered to be a part of the active layer 62. That is, the modulator 66 can be formed by doping a portion of the barrier layers 64 of the active layer 62. According to the present invention, the modulation layer 65c of the modulator 66, like the quantum well layer 63, can be operated as a gain region to contribute to the oscillation of the laser device. For this, it is preferable that the distance between the modulation layer 65c and the quantum well layer 63 closest to the modulation layer 65c is equal to 1/2 of the oscillation wavelength, like the distance between the quantum well layers 63.

FIG. 5 shows an electrode structure for applying a reverse bias voltage to the modulator 66 through the first and second doped barrier layers 65a and 65b. First, the modulation layer 65c is partially formed on the top surface of the first doped barrier layer 65a in a center portion, and a first electrode 68 is formed along the top edge of the first doped barrier layer 65a to apply a voltage to the first doped barrier layer 65a. Although the sectional view of FIG. 5 shows two first electrodes 68 as if they are formed on both top ends of the first doped barrier layer 65a, the first electrode 68 is actually a ring shaped single electrode. Further, a second electrode 69 is formed along the top edge of the window layer 67 to apply a voltage to the second doped barrier layer 65b. Similarly, the second electrode 69 is a single electrode shaped like, for example, a ring.

The operation of the aforementioned modulator integrated semiconductor laser device will now be described in detail.

First, as shown in FIG. 5, a pump laser 70 emits a light beam at a wavelength λ1 shorter than a wavelength λ2 emitted by the active layer 62. The light beam emitted from the pump laser 70 is incident on the active layer 62 to excite the active layer 62. Generally, an optical pumping method or an electric pumping method can be used to excite an active layer of a VECSEL. In the optical pumping method, optical energy is applied to an active layer by using a pump laser, and in the electric pumping method, electrical energy is applied to an active layer through a metal contact. In the present invention, the optical pumping method is preferably used, in order to easily apply a reverse bias voltage to the modulator 66 that can be considered to be a part of the active layer 62.

As described above, when the λ1-wavelength light beam emitted from the pump laser 70 is incident on the window layer 67 through a collimating lens 73, the active layer 62 is excited by the λ1-wavelength light beam to emit light at a wavelength λ2. The λ2-wavelength light emitted from the active layer 62 is repeatedly reflected between the lower DBR layer 61 and the external mirror 71 through the active layer 62. This repetition amplifies the λ2-wavelength light in the active layer 62. Then, a portion of the amplified light is output to the outside through the external mirror 71 as a laser beam, and the remainder is reflected again to the active layer 62 for optical pumping. If the SHG crystal 72 is placed on the optical path between the external mirror 71 and the window layer 67, light having a shorter wavelength λ3 due to the SHG crystal 72 can be output to the external mirror 71.

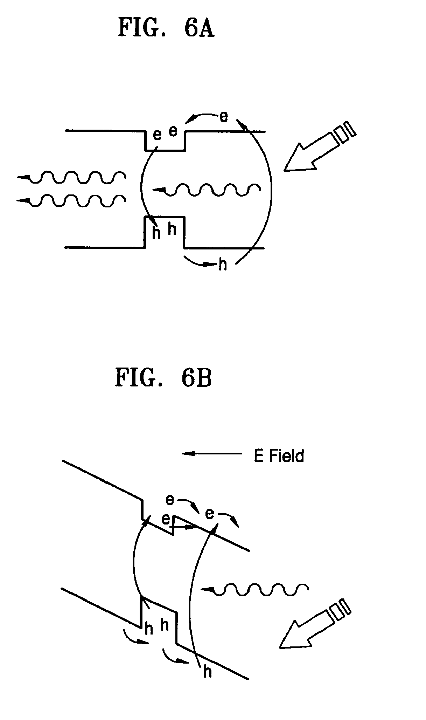

At this time, the modulation layer 65c, which has the same energy band gap as the quantum well layer 63, like other quantum well layers 63 in the active layer 62, emits light by recombination of an electron and a hole. FIG. 6A is an energy band graph showing the operation of the modulation layer 65c in this case. Referring to FIG. 6A, the modulation layer 65c is excited by light generated by the pump laser 70 or other quantum well layers 63. As a result, light is emitted from the modulation layer 65c when electrons in the conduction band of the modulation layer 65c move for recombination with holes in the valance band.

If a reverse bias voltage is applied to the modulator 66 through the first and second barrier layers 65a and 65b when the quantum well layer 63 and the modulation layer 65c are excited by the pump laser 70, the energy band graph of the modulation layer 65c changes as shown in FIG. 6B. That is, the electric field generated in the modulator 66 by the reverse bias voltage causes the energy band of the modulator 66 to incline as shown in FIG. 6B, and thus the energy band gap of the modulation layer 65c becomes narrower. As a result, electrons and holes escape from the quantum well of the modulation layer 65c, or they escape from the first and second barrier layers 65a and 65b by tunneling. Therefore, the modulation layer 65c does not act as a gain region any more, but instead absorbs light. Accordingly, the resonance and light emission of the laser device is wholly stopped.

Based on this principle, for example, the optical output power of the laser device can be modulated into a high frequency by switching the reverse bias voltage to the modulator 66 on and off very rapidly via a high frequency generator.

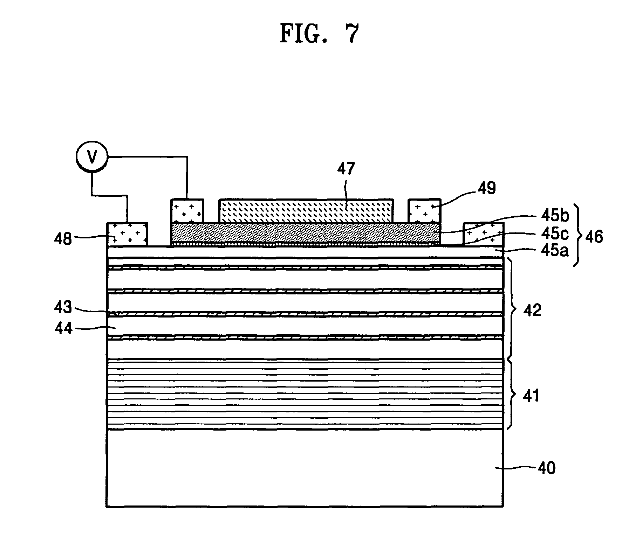

FIG. 7 is a sectional view of a modulator integrated semiconductor laser device according to another embodiment of the present invention. In FIG. 7, an external mirror and a pump laser are not shown.

The semiconductor laser device shown in FIG. 7 differs from the semiconductor laser device shown in FIG. 5 only in the location of the second electrode. That is, the laser device, like the embodiment shown in FIG. 5, includes a substrate 40, a lower DBR layer 41, an active layer 42, and a modulator 46. Therefore, the laser device, like the embodiment shown in FIG. 5, also includes quantum well layers 43, barrier layers 44, a modulation layer 45c, a first doped barrier layer 45a, and a second doped barrier layer 45b. Further, a first electrode 48, like the embodiment shown in FIG. 5, is formed along the top edge of the first doped barrier layer 45a to apply voltage to the first doped barrier layer 45a. However, the laser device shown in FIG. 7, unlike the embodiment shown in FIG. 5, includes a window layer 47 partially formed on the top center of the second doped barrier layer 45b, and a second electrode 49 formed along the top edge of the second doped barrier layer 45b to apply voltage to the second doped barrier layer 45b. In this embodiment shown in FIG. 7, the second electrode 49 contacts the top surface of the second doped barrier layer 45b to inject a reverse bias voltage more efficiently.

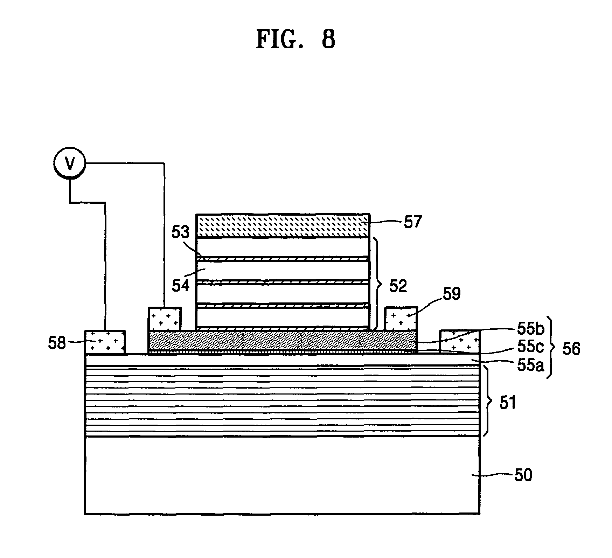

FIG. 8 is a sectional view of a modulator integrated semiconductor laser device according to another embodiment of the present invention. In FIG. 8, an external mirror and a pump laser are again not shown.

The laser device shown in FIG. 8 differs from the other embodiments in that the modulator is formed under the active layer. That is, the laser device includes a lower DBR layer 51, a modulator 56, an active layer 52, and a window layer 57 that are sequentially formed on a substrate 50. However, the active layer 52 and the modulator 56 have the same structure as that shown in the embodiment of FIG. 5. That is, the modulator 56 includes a first doped barrier layer 55a, a modulation layer 55c formed on the first doped barrier layer 55a, and a second doped barrier layer 55b formed on the modulation layer 55c and doped with a different type from the first doped barrier layer 55a. Further, the active layer 52 includes at least one quantum well layer 53 and at least one barrier layer 54, alternately stacked.

Here, as shown in FIG. 8, the modulation layer 55c is partially formed on the top center of the first doped barrier layer 55a, and the active layer 52 is partially formed on the top center of the second doped barrier layer 55b. Further, a first electrode 58 is formed along the top edge of the first doped barrier layer 55a to apply a voltage to the first doped barrier layer 55a, and a second electrode 59 is formed along the top edge of the second doped barrier layer 55b to apply a voltage to the second doped barrier layer 55b.

The description above shows that the modulator integrated semiconductor laser device of the present invention is designed such that the modulator is formed in the active layer instead of in a reflection layer, and the modulator, like the active layer, acts as a gain region. Therefore, the modulator integrated semiconductor laser device can have a high lasing efficiency since the modulator contributes to the lasing of the laser device. Also, the lasing conditions of the laser device are easily satisfied according to the present invention, so that the laser device can be more easily manufactured. Furthermore, since the present invention utilizes the VECSEL, that has a high output power, the present invention can be used for laser modulation of a laser TV.

While the present invention has been particularly shown and described with reference to exemplary embodiments thereof, it will be understood by those of ordinary skill in the art that various changes in form and detail may be made therein without departing from the scope of the present invention as defined by the following claims.

## Claims

1. A semiconductor laser device comprising:
a substrate;
a lower distributed Bragg reflector layer formed on the substrate;
an active layer formed on the lower distributed Bragg reflector layer and including a plurality of barrier layers alternating with a plurality of quantum well layers; and
an external mirror spaced apart from the top of the active layer to transmit a portion of light emitted from the active layer and to reflect the remainder to the active layer,
wherein two of the plurality of barrier layers contacting both sides of at least one of the plurality of quantum well layers are doped with different types.

2. The semiconductor laser device of claim 1, wherein when a reverse bias is applied through the doped barrier layers, the at least one quantum well layer between the doped barrier layers absorbs the light to restrain oscillation of the laser device.

3. The semiconductor laser device of claim 1 or 2, further comprising a pump laser to supply pumping energy to the active layer.

4. The semiconductor laser device of claim 1, 2 or 3, further comprising a window layer formed on the active layer using a material having a larger energy band gap than the active layer.

5. A semiconductor laser device comprising:
a substrate;
a lower distributed Bragg reflector layer formed on the substrate;
an active layer formed on the lower distributed Bragg reflector layer by alternately stacking at least one barrier layer and at least one quantum well layer;
a modulator including a first doped barrier layer formed on or under the active layer, a modulation layer formed on the first doped barrier layer, and a second doped barrier layer formed on the modulation layer and doped with a different type from the first doped barrier layer; and
an external mirror spaced apart from the top of the active layer to transmit a portion of light emitted from the active layer and to reflect the remainder to the active layer.

6. The semiconductor laser device of claim 5, wherein the first and second doped barrier layers are formed of the same material as the barrier layer of the active layer, and the modulation layer is formed of the same material as the quantum well layer of the active layer.

7. The semiconductor laser device of claim 6, wherein the modulation layer has the same energy band gap as the quantum well layer.

8. The semiconductor laser device of claim 6 or 7, wherein when a reverse bias is applied to the modulator through the first and second doped barrier layers, the modulation layer between the first and second doped barrier layers absorbs the light to restrain oscillation of the laser device.

9. The semiconductor laser device of claim 8, wherein when the reverse bias is not applied to the modulator, the modulation layer, like the quantum well layer of the active layer, acts as a gain region.

10. The semiconductor laser device of claim 9, wherein the distance between the modulation layer and one of the quantum well layers adjacent to the modulation layer is equal to 1/2 of an emission wavelength.

11. The semiconductor laser device of any of claims 5 to 10, further comprising a pump laser to supply pumping energy to the active layer.

12. The semiconductor laser device of any of claims 5 to 11 wherein the modulator is formed on the active layer.

13. The semiconductor laser device of claim 12, further comprising a window layer formed on the modulator using a material having a larger energy band gap than the active layer.

14. The semiconductor laser device of claim 13, wherein the modulation layer is partially formed on the top center of the first doped barrier layer.

15. The semiconductor laser device of claim 14, wherein a first electrode is formed along a top edge of the first doped barrier layer to apply a voltage to the first doped barrier layer, and a second electrode is formed along an edge of the window layer to apply a voltage to the second doped barrier layer.

16. The semiconductor layer device of claim 15, wherein the window layer is partially formed on the top center of the second doped barrier layer, a first electrode is formed along a top edge of the first doped barrier layer to apply a voltage to the first doped barrier layer, and a second electrode is formed along a top edge of the second doped barrier layer to apply a voltage to the second doped barrier layer.

17. A semiconductor laser device according to any of claims 5 to 11, wherein the modulator including a first doped barrier layer is formed on the lower distributed Bragg reflector layer.

18. The semiconductor laser device of claim 17, further comprising a window layer formed on the active layer using a material having a larger energy band gap than the active layer.

19. The semiconductor laser device of claim 17, wherein the modulation layer is partially formed on the top center of the first doped barrier layer and the active layer is partially formed on the top center of the second doped barrier layer.

20. The semiconductor laser device of claim 19, wherein a first electrode is formed along a top edge of the first doped barrier layer to apply a voltage to the first doped barrier layer, and a second electrode is formed along a top edge of the second doped barrier layer to apply a voltage to the second doped barrier layer.
